# EUROPÄISCHE PATENTSCHRIFT

(11) **EP 1 260 849 B1**
(45) Veröffentlichungstag und Bekanntmachung des Hinweises auf die Patenterteilung: **08.12.2004**
(21) Anmeldenummer: 02009642.6
(22) Anmeldetag: 27.04.2002
(51) Int. Cl.: G02B 27/28, G03F 7/20, G02B 5/30

(54) **Polarisations-Kompensator und Mikrolithographie-Projektionsanlage mit Polarisations-Kompensator**
Polarisation compensator and microlithography projection device with polarisation compensator
Compensateur de polarisation et dispositif de projection microlithographique avec compensateur de polarisation

(30) Priorität: 22.05.2001 DE 10124803
(43) Veröffentlichungstag der Anmeldung: 27.11.2002
(73) Patentinhaber: Carl Zeiss SMT AG, 73447 Oberkochen (DE)
(72) Erfinder: Schuster, Karl-Heinz, 89551 Königsbronn (DE)
(74) Vertreter: Patentanwälte Ruff, Wilhelm, Beier, Dauster & Partner

(56) Entgegenhaltungen:
- EP-A- 0 764 858
- US-A- 3 146 294
- US-A- 5 001 716
- US-A- 5 638 200
- US-A- 6 072 629
- BORN, M.; WOLF, E.: "Principles of optics" 1980 , PERGAMON PRESS , OXFORD XP002211134 * Seite 694, Absatz 3 *

## Beschreibung

Die Erfindung betrifft ein segmentiertes Verzögerungselement zur Umwandlung eines im wesentlichen senkrecht zu einer Eintrittsseite des Verzögerungselementes eintretenden Lichtbündels in ein austretendes Lichtbündel, welches über seinen Querschnitt eine vorgegebene Verteilung lokal unterschiedlicher Polarisationszustände aufweist, nach dem Oberbegriff von Anspruch 1.

Bei mikrolithographischen Projektionsbelichtungsanlagen wird häufig der Polarisationszustand des zur Bilderzeugung genutzten Lichtes gezielt beeinflußt, um die Abbildungsqualität zu verbessern. Hierzu können gattungsgemäße Verzögerungselemente im Beleuchtungssystem und/oder im Projektionsobjektiv eingesetzt werden.

Aus der DE 195 35 392 ist ein derartiges segmentiertes Verzögerungselement bekannt, das für den Einsatz im Beleuchtungssystem vorgesehen ist und ein austretendes Lichtbündel mit im gesamten Querschnitt im wesentlichen in radialer Richtung polarisiertem Licht erzeugt. Die radiale Polarisation ist für Objektive mit typischer bildseitiger numerischer Apertur von ca. 0,5 bis ca. 0,7 und Photoresist ohne Antireflexbeschichtung gut geeignet, um Störungen aufgrund der polarisationsselektiven Reflexion am Photoresist unter Einfallswinkeln im Bereich des Brewster-Winkels zu unterdrücken. Dadurch ergibt sich eine optimale Einkopplung des Lichts in den Resist.

Eine Ausführungsform zur Umwandlung von eintretendem linear polarisierten Licht in radial polarisiertes Licht umfaßt eine Vielzahl flächenfüllend angeordneter, sechseckiger Halbwellenplatten aus doppelbrechendem Material, deren kristallographische Hauptachse senkrecht zur Richtung des einfallenden Lichtbündels so ausgerichtet sind, daß jede Halbwellenplatte die Polarisationsrichtung des einfallenden Lichtes in Richtung eines die Halbwellenplatte durchschneidenden, auf die optische Achse gerichteten Radius umlenkt. Diese segmentierte Anordnung erzeugt die gewünschte vorgegebene Verteilung lokal unterschiedlicher Polarisationsvorzugsrichtungen ausschließlich durch Drehung des Polarisationszustandes des eintretenden Lichtes, nicht durch Filterung. Dadurch wird eine hohe Transmission erreicht. Die Herstellung derartiger Verzögerungselemente ist aufgrund des segmentierten Aufbaus aufwendig. Außerdem kann die Dicke des Verzögerungselementes, die durch die verwendete Wellenlänge und durch den senkrecht zur kristallographischen Hauptachse vorliegenden Brechzahlunterschied der senkrecht zueinander polarisierten Feldkomponenten festgelegt ist, je nach Wellenlänge und verwendetem Material sehr gering werden, was erhöhten Aufwand bei der Fassung derartiger Elemente erfordert.

Aus der US 5,365,371 und dem zugehörigen CIP-Patent US 5,436,761 ist eine Projektionsbelichtungsanlage für die Mikrolithographie bekannt, bei der ebenfalls eine radial gerichtete Linearpolarisation des Lichtes eingeführt wird, um Störungen bei der Bilderzeugung im Resist zu unterbinden. Es werden verschiedene Ausführungen für Polarisationsfilter gezeigt, die zu hohem Lichtverlust führen. Die Radialpolarisatoren sind im Bereich der Pupillenebene bzw. der Systemapertur des Projektionsobjektives untergebracht.

Aus der US 5,691,802 ist ein katadioptrisches Projektionsobjektiv bekannt, in dessen Pupillenebene eine polarisierende Platte angeordnet werden kann. Diese segmentierte Platte hat eine innere Kreiszone und eine äußere Ringzone, die zueinander orthogonal linear polarisiertes Licht erzeugen und zugleich verschiedene Brechungsindizies haben. Damit werden zwei nicht interferierende Lichtbündel geschaffen, die unterschiedliche Bildebenen erzeugen. Das Ganze dient zur Vergrösserung der Schärfentiefe.

Aus der US 4,755,027 sind polarisierende Axicon-Anordnungen bekannt, die mit Hilfe konischer Oberflächen austretende Lichtbündel erzeugen können, die an jedem Punkt ihres Querschnittes entweder eine radiale oder eine tangentiale Polarisationsvorzugsrichtung in Bezug auf die optische Achse haben, also jeweils eine zylindersymmetrische Verteilung unterschiedlicher Polarisationsvorzugsrichtungen.

Aus dem Fachbuch von Born, Wolf: "Principles of optics", Pergamon Press, Oxford, 1980, Seite 694 ist ein sogenannter Berek-Kompensator bekannt, der im Bereich der biologischen Mikroskopie z.B. zur Messung von optischen Weglängendifferenzen in Fäden aus doppelbrechendem Material eingesetzt wird. Er besteht aus einer kippbar gelagerten Scheibe aus doppelbrechendem Material, dessen kristallographische Hauptachse senkrecht auf den Plattenflächen steht. Durch Kippung der Scheibe können verschiedene Weglängendifferenzen eingestellt werden, deren Ausmaß als Funktion des Kippwinkels kalibriert werden kann.

Es ist Aufgabe der Erfindung, ein Verzögerungselement der eingangs erwähnten Art zu schaffen, das sich durch einfachen Aufbau, kostengünstige Herstellung und hohe Transmission auszeichnet. Das Verzögerungselement soll insbesondere dazu geeignet sein, aus einfallendem zirkular oder linear polarisierten Licht austretendes Licht mit zylindersymmetrischer Verteilung der Polarisationsvorzugsrichtungen zu erzeugen.

Zur Lösung dieser Aufgabe schlägt die Erfindung ein Verzögerungselement mit den Merkmalen von Anspruch 1 vor. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Das segmentierte Verzögerungselement wird in dieser Anmeldung auch als "Polarisator" bezeichnet, wobei dieser Begriff allgemein im Sinne von "polarisationsoptisch wirksames Element" zu verstehen ist, nicht im Sinne von "Polarisationsfilter". Die kristallographische Hauptachse wird aus Vereinfachungsgründen auch als "Kristallachse" bezeichnet. Der "schiefe" Durchtritt von Licht wird auch als "windschiefer" Durchtritt bezeichnet.

Bei erfindungsgemäßen Verzögerungselementen bzw. Polarisatoren ist zur Erzeugung einer Phasenverzögerung zwischen senkrecht zueinander polarisierten Feldkomponenten des durchtretenden Lichts mindestens ein doppelbrechendes Element vorgesehen, das eine Kristallachse (kristallographische Hauptachse) und eine axiale Dicke hat. Der beleuchtete Querschnitt des Polarisators ist in eine Vielzahl von Bereichen bzw. Feldern aufgeteilt, die vorzugsweise im wesentlichen flächenfüllend angeordnet sind. Mindestens einer dieser Bereiche ist so ausgebildet, daß die Durchtrittsrichtung des Lichts in diesem Bereich schief bzw. windschief zur Richtung der Kristallachse des Bereichs verläuft. Vorzugsweise ist jeder der Bereiche in dieser Weise ausgebildet. Ein windschiefer Durchtritt zeichnet sich dadurch aus, daß die Durchtrittsrichtung in einem Neigungswinkel von mehr als 0° und weniger als 90° zur Richtung der Kristallachse verläuft. Die Durchtrittsrichtung und die Kristallachse spannen eine Durchtrittsebene auf. Für jeden der windschief durchstrahlten Bereiche sind die axiale Dicke und der Neigungswinkel derart aneinander angepaßt, daß eine optische Weglängendifferenz der Feldkomponenten in diesem Bereich nach Durchtritt durch den Polarisator einem vorgegebenen Gangunterschied entspricht. Dieser ist vorzugsweise über den gesamten Querschnitt gleich. Die Orientierung der Durchtrittsebene bzw. der Neigungsrichtung ist für jeden windschief durchstrahlten Bereich so eingestellt, daß sich am Austritt die für diesen Bereich lokal gewünschte Polarisationsvorzugsrichtung ergibt.

Der Polarisator wirkt also in jedem seiner windschief durchstrahlten Bereiche wie eine Verzögerungsplatte, bei der sich der Gangunterschied G gemäß G= W x |nₐₒ - nₒ| aus dem Produkt der in Durchtrittsrichtung durchlaufenen Weglänge W zwischen Eintritt und Austritt und dem Betrag der Differenz der Brechungsindizes nₒ und nₐₒ für die beiden senkrecht zueinander polarisierten Feldkomponenten (ordentlicher Strahl und außerordentlicher Strahl) ergibt. Dabei ist die den Gangunterschied mitbestimmende Brechzahldifferenz der Feldkomponenten vom Neigungswinkel NW und von der Art des doppelbrechenden Materials abhängig und kann entsprechend durch Wahl des Neigungswinkels eingestellt werden.

Wird beispielsweise ein kleiner Neigungswinkel zur Kristallachse eingestellt, so ist die Brechzahldifferenz, welche in Richtung der Kristallachse verschwindet, relativ klein, so daß zur Erzielung eines gewünschten Gangunterschiedes die axiale Dicke entsprechend groß gewählt werden kann. Dies erleichtert die Fertigung und das Handling erfindungsgemäßer Polarisatoren, die gegebenenfalls als freitragende Komponenten ausgeführt sein können. Über die Wahl der axialen Dicke kann die Wirkungsweise des Polarisators an den Polarisationszustand des einfallenden Lichtes und die gewünschte Polarisationsverteilung des austretenden Lichtes angepaßt werden. Wird beispielsweise ein Gangunterschied von einem Viertel der Lichtwellenlänge eingestellt, so ist durch jeden der Bereiche eintretendes zirkular polarisiertes Licht in austretendes linear polarisiertes Licht umwandelbar. Über die Neigungsrichtung ist für jeden Bereich die Ausrichtung der Polarisationsvorzugsrichtung in der Austrittsebene einstellbar, beispielsweise in tangentialer oder radialer Richtung zur optischen Achse des Polarisators. Bei Einstellung eines Halbwellen-Gangunterschiedes ist eine lokale Drehung von einfallendem linear polarisiertem Licht in austretendes linear polarisiertes Licht möglich, welches wiederum durch geeignete lokale Einstellung der Neigungsrichtung in den Bereichen vorzugsweise in jeden Bereich radial oder tangential zur optischen Achse ausgerichtet ist.

Eine vorteilhafte Weiterbildung zeichnet sich dadurch aus, daß ein doppelbrechendes Element mit einer im wesentlichen parallel zur optischen Achse ausgerichteten Kristallachse vorgesehen ist und daß dem doppelbrechenden Element für jeden Bereich eine ablenkende Struktur zugeordnet ist, die das einfallende Licht so ablenkt, daß dieses mit dem für den Bereich vorgesehenem Neigungswinkel und der Neigungsrichtung den Bereich durchdringt. Mit einem einzigen den Querschnitt des Polarisators füllenden doppelbrechenden Element ist somit ein unsegmentierter Polarisator mit einfachem Aufbau möglich, der besonders leicht herstellbar ist.

Um einen Lichtaustritt parallel zum Lichteintritt zu ermöglichen, sind vorzugsweise auf einer Eingangsseite des doppelbrechenden Elementes ablenkende Strukturen zur Ablenkung des einfallenden Lichtes in die windschiefe Durchtrittsrichtung und auf der Austrittsseite zugeordnete ablenkende Strukturen zur Rückgängigmachung der Ablenkung vorgesehen. Beispielsweise kann das doppelbrechende Element durch eine planparallele Platte aus Magnesiumfluorid oder Quarzkristall gebildet sein, auf deren Eintrittsseite und/oder Austrittsseite die ablenkenden Strukturen in Form entsprechend strukturierter Oberflächenbereiche erzeugt sind. Auf diese Weise ist ein aus einem einzigen optisch wirksamen Element bestehender Polarisator möglich, der im wesentlichen die Form einer dünnen Platte hat und somit auch bei beschränktem Bauraum an geeigneter Stelle innerhalb einer Projektionsbelichtungsanlage eingebaut werden kann.

Die ablenkenden Strukturen jedes Bereiches dienen dazu, das in den Bereich einfallende Licht in die für diesen Bereich vorgesehene Durchtrittsrichtung umzulenken bzw. diese Umlenkung rückgängig zu machen. Es kann sich dabei um eine beugende Struktur, beispielsweise nach Art eines linearen Gitters, um eine brechende Struktur, beispielsweise nach Art einer Fresnell-Oberfläche, oder um eine Struktur handeln, bei der sowohl Lichtbeugung als auch Brechung zur Ablenkung beitragen, beispielsweise nach Art eines geblazeden Gitters. Auch holographische Strukturen sind möglich.

Zweckmäßig ist es, den beleuchteten Querschnitt in kleine Felder bzw. Bereiche konstanter Ablenkung aufzuteilen, beispielsweise in kleine Sechseck-Bereiche, die den gesamten beleuchteten Querschnitt des Polarisators mehr oder weniger lückenlos ausfüllen. Auch andere vorzugsweise vieleckige Bereichsformen, z.B. Quadrate oder Dreiecke sind möglich. Die Anzahl der Bereiche oder Felder liegt bevorzugt in der Größenordnung von 10 oder 100 oder darüber, so daß die Bereiche bevorzugt typische mittlere Querschnittsflächen von weniger als 10%, insbesondere zwischen 10% und 1% der Gesamtquerschnittsfläche haben. Die Größe der Bereiche kann dabei der für den Anwendungsfall zulässigen Richtungstoleranz der lokal gewünschten Polarisationsvorzugsrichtung angepaßt werden. Diese liegt bei bevorzugten Ausführungsformen im Bereich von ±2% oder darunter. Durch kleinere Bereichsgrößen kann eine fast stufenlose Verteilung der gewünschten lokalen radialen oder tangentialen Polarisation erzielt werden. Auch ein kontinuierlicher Übergang der Strukturen ohne definierte Bereichsgrenzen ist möglich. Ebenso ist es möglich, daß zwischen den wirksamen Bereichen kleine Lücken bleiben, die besonders bei Einsatz der Polarisatoren im Beleuchtungssystem tolerierbar sind.

Polarisatoren der beschriebenen Art sind besonders günstig herstellbar. Ausgangskristalle aus Siliciumdioxid oder Magnesiumfluorid zur Herstellung der doppelbrechenden Platte sind gerade in der benötigten Orientierung der Kristallachse auch in großen Abmessungen bis beispielsweise 20 oder 30 cm Durchmesser insbesondere für Siliciumdioxid verfügbar. Zur Herstellung eines Polarisators ist nur eine Platte zu bearbeiten, die aufgrund der typischen Dicke von einigen zehntel Millimetern relativ unempfindlich und bei der Bearbeitung gut handhabbar ist. Die Herstellung der ablenkenden, d.h. diffraktiven und/oder refraktiven Strukturen auf den Plattenoberflächen kann mit Hilfe geeigneter lithographischer Prozesse erfolgen, so daß bei großen Stückzahlen die Bereitstellungskosten niedrig bleiben können. Auch eine mechanische Strukturerzeugung ist prinzipiell möglich.

Eine andere Klasse erfindungsgemäßer Polarisatoren zeichnet sich dadurch aus, daß im Querschnitt des Polarisators mehrere doppelbrechende Elemente vorzugsweise flächenfüllend angeordnet sind, wobei bei jedem der doppelbrechenden Elemente die Kristallachse in der eingangs erwähnten Art windschief gegenüber der optischen Achse des Polarisators so gekippt ist, daß sich für den Bereich der gewünschten Neigungswinkel und die Neigungsrichtung ergibt. Es handelt sich hier also um segmentierte Polarisatoren, deren Aufbau ähnlich sein kann wie derjenige, der in Fig. 1 der DE 195 35 392 gezeigten Ausführungsformen, jedoch mit dem Unterschied, daß bei erfindungsgemäßen Polarisatoren die Kristallachsen der Bereiche schräg zur optischen Achse und zur Plattenebene ausgerichtet sind.

Die Erfindung betrifft auch eine Mikrolithographie-Projektionsanlage, in die mindestens ein erfindungsgemäßer Polarisator eingebaut ist. Die Projektionsanlage hat eine mit einer Lichtquelle, beispielsweise einem Laser, ausgestattete Beleuchtungseinrichtung zur Beleuchtung einer Maske und ein der Beleuchtungseinrichtung nachgeschaltetes Projektionsobjektiv zur Abbildung des von der Maske getragenen Musters in die Bildebene des Projektionsobjektives, in der sich das zu strukturierende Element, beispielsweise ein mit Photoresist beschichteter Wafer, befindet. Durch die Integration eines oder mehrerer erfindungsgemäßer Polarisatoren lassen sich die Möglichkeiten der Optik voll ausnutzen. Beispielsweise ergibt die Verwendung eines Polarisators zur Erzeugung von radialer Polarisation eine Verbesserung der Homogenität und des Wirkungsgrades der Lichteinkopplung in die Resistschicht, da die Reflexion am Resist, aber auch an allen nach dem Polarisator angeordneten Linsen, gleichmäßig reduziert wird. Für unter großen Winkeln (bis zum Brewster-Winkel) einfallendes Licht ist der Effekt am stärksten gerade dort, wo die Lichtintensität aufgrund von Randabfall am geringsten ist. Die Störung der Auflösung durch Streulicht, auch an der Grenzschicht zwischen Resist und Wafer, sind homogenisiert und verringert.

Tangentiale Polarisation kann dagegen bei antireflexbeschichtetem Resist und sehr hohen bildseitigen numerischen Aperturen vorteilhaft sein. Unter diesen Bedingungen wird der Interferenzkontrast bestimmend. Dieser ist optimal, wenn eine Zweistrahlinterferenz von Strahlen mit senkrecht zur Einfallsebene orientierter Polarisation erfolgt. Es hat stich gezeigt, daß durch die tangentiale Polarisation eine erhebliche Kontrasterhöhung möglich ist.

Erfindungsgemäße Polarisatoren werden vorzugsweise im Beleuchtungssystem, also zwischen der Lichtquelle und der durch diese beleuchteten Maske angeordnet. Eine Anordnung früh im Strahlengang ist besonders für radial polarisierende Polarisatoren vorteilhaft, um die Vorteile der Radialpolarisation bei der Einkopplung in nachfolgende Linsen nutzen zu können. Es ist auch zu berücksichtigen, daß asymmetrische optische Elemente, beispielsweise Umlenkspiegel, wie sie zur Kürzung der Baulänge von Beleuchtungssystemen oder in katadioptrischen Projektionsobjektiven vorgesehen sind, i.d.R. den Polarisationszustand ändern. Um eine möglichst störungsfreie "Durchschleusung" der am Ausgang des Polarisators vorherrschenden Polarisationsverteilung bis in die Bildebene des Projektionsobjektives zu gewährleisten, ist es daher vorteilhaft, den Polarisator in Lichtflußrichtung hinter dem letzten polarisierenden, nicht zur optischen Achse der Anlage symmetrischen Bauteil anzuordnen. Dieses kann bei Anlagen mit rein refraktiven Projektionsobjektiven der letzte Umlenkspiegel des Beleuchtungssystemes sein, bei katadioptrischen Projektionsobjektiven auch der letzte Spiegel des Projektionsobjektivs.

Besonders bevorzugt ist eine Anordnung des Polarisators innerhalb des Beleuchtungssystemes in einer Ebene, die zur Blendenebene des Projektionsobjektives konjugiert ist. Dadurch kann Einfluß auf die Polarisationsverteilung im Bereich der Systemapertur des Projektionsobjektives genommen werden, ohne daß in diesem Bereich ein Polarisator eingebaut sein muß. Dies ist vorteilhaft, da der Polarisator die Anforderungen der Beleuchtung bezüglich Phase und Strahlablenkung leicht erfüllen kann, was im Projektionsobjektiv erheblich schwerer wäre. Eine volle Reproduktion des am Ausgang des Polarisators vorherrschenden Polarisationsverteilung ist jedoch, wie oben erwähnt, nur möglich, wenn sich hinter dem Polarisator keine die Polarisation wesentlich beeinflussenden Bauteile mehr befinden, oder wenn deren Einflüsse sich kompensieren.

Die günstige Anordnung von Polarisatoren an unkritischen Stellen innerhalb des Beleuchtungssystemes erlaubt es auch, den Polarisator auswechselbar zu gestalten, so daß je nach Anwendungsfall durch Auswechslung geeigneter Polarisatoren z.B. zwischen zirkularer, radialer und tangentialer Polarisation im Waferbereich umgeschaltet werden kann.

Die vorstehenden und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhaft sowie für sich schutzfähige Ausführungen darstellen können. Es zeigen:
- Fig. 1: einen schematischen Schnitt durch eine bevorzugte Ausführungsform eines erfindungsgemäßen Polarisators mit ablenkenden Strukturen an Eingangsseite und Ausgangsseite;
- Fig. 2: ein Diagramm zur Erläuterung der Funktionsweise des Polarisators in Fig. 1;
- Fig. 3: eine Draufsicht auf den Polarisator von Fig. 1 mit einem Raster sechseckförmiger, ablenkender Bereiche zur Erzeugung von radial polarisiertem Licht aus zirkular polarisiertem Licht;
- Fig. 4: die radialen Polarisationsrichtungen des aus dem Polarisator in Fig. 3 austretenden Lichtbündels;
- Fig. 5: die ausgangsseitigen Polarisationsrichtungen einer anderen Ausführungsform eines einstückigen Polarisators zur Erzeugung von tangential polarisiertem Licht;
- Fig. 6: eine schematische Ansicht einer Ausführungsform eines segmentierten Polarisators gemäß der Erfindung; und
- Fig. 7: eine Mikrolithographie-Projektionsbelichtungsanlage mit einem erfindungsgemäßen Polarisator im Beleuchtungssystem.

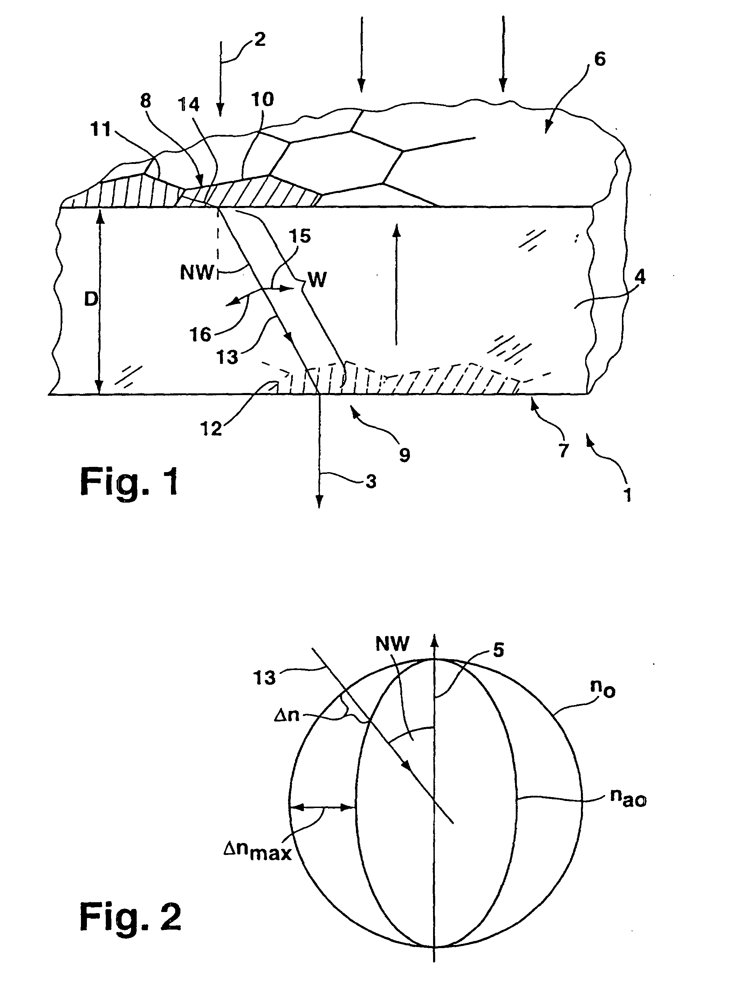

In Fig. 1 ist eine bevorzugte Ausführungsform eines erfindungsgemäßen Polarisators 1 zur Umwandlung von einfallendem zirkular polarisiertem Licht 2 in austretendes, radial polarisiertes Licht 3 gezeigt. Das Herzstück des Radialpolarisators ist eine planparallele Platte 4 aus einem anisotopen, optisch einachsigem Kristall, dessen Kristallachse 5 im wesentlichen senkrecht zu den planparallelen Plattenoberflächen 6, 7 steht. Das Material der Platte ist für Licht der vorgesehenen Arbeitswellenlänge transparent, wobei bevorzugte Arbeitswellenlängen im UV-Bereich mit Wellenlängen unterhalb ca. 260 nm liegen. Die einstückige Platte 4 kann z.B. für Licht mit 157 nm Wellenlänge aus Magnesiumfluorid und für Licht mit 193 nm Wellenlänge aus Magnesiumfluorid oder Quarz (Siliziumdioxid) bestehen. Die Platte 4 wird in den Strahlengang der zu beeinflussenden Strahlung so eingebaut, daß die Kristallachse 5 parallel, bzw. die Plattenflächen 6, 7 senkrecht zur optischen Achse des Systems stehen. Die axiale Dicke D der Platte liegt typischerweise in der Größenordnung mehrerer Zehntel Millimeter und kann gegebenenfalls so groß sein, beispielsweise um ca. 0,5mm - 3mm, daß die Platte selbsttragend eingebaut werden kann. Es ist auch möglich, zur Unterstützung der Platte einen Träger aus isotropem Material, beispielsweise Quarzglas oder Calciumfluorid, vorzusehen, auf dem die Platte in Gebrauchslage unter Eigengewicht aufliegt.

Auf der Eintrittsseite 6 und der Austrittsseite 7 der Platte sind einander zugeordnete, ablenkende Strukturen 8, 9 mit aufeinander abgestimmten Ablenkeigenschaften ausgebildet. Im Beispielsfall liegen die ablenkenden Strukturen in Form von Sechseckbereichen gleicher Größe vor, die die gesamte Eintrittsseite 6 bzw. Austrittsseite 7 flächenfüllend bedecken. In jedem Sechseckbereich ist eine nach Art eines linearen Beugungsgitters wirkende ablenkende Struktur vorgesehen, wobei sich die Ausrichtungen der parallelen Gitterlinien zwischen benachbarten Bereichen 10, 11 i.d. R. um einige Winkelgrade unterscheiden.

Anhand der einander zugeordneten, seitlich leicht gegeneinander versetzten diffraktiven Strukturen 10 (auf der Oberseite 6) und 12 (auf der Unterseite 7) wird nun die Wirkungsweise des Polarisators näher erläutert. Das parallel zur optischen Achse des Systems einfallende Licht 2 trifft an der Eingangsseite 6 auf die ablenkende Struktur 10. Dieses Transmissionsgitter lenkt die Strahlung durch Beugung so ab, daß die Durchtrittsrichtung 13 der ersten Beugungsordnung innerhalb der Kristallplatte 4 windschief zur Kristallachse 5 verläuft. Als windschief wird hier jede Durchtrittsrichtung bezeichnet, die weder parallel, noch senkrecht zur Kristallachse 5 steht. Solche Durchtrittsrichtungen sind durch einen Neigungswinkel NW von mehr als 0° und weniger als 90° gekennzeichnet. Die diffraktive Struktur 12 an der Ausgangsseite 7 macht aufgrund der gleichen Gitterkonstante wie die Eingangsstruktur 10 diese Ablenkung wieder rückgängig, so daß das austretende Licht 3 parallel versetzt zum entsprechenden einfallenden Licht parallel zur optischen Achse des Systems austritt. Diese Verhältnisse sind in Fig. 1 stark übertrieben gezeichnet. Die Richtung der Kristallachse 5 und die Durchtrittsrichtung 13 spannen eine die Neigungsrichtung definierende Durchtrittsebene auf, deren Schnittlinie 14 mit der Eintrittsseite 6 der Platte senkrecht zu den Linien der ablenkenden Gitterstruktur 10 verläuft. Die vom Licht innerhalb des Kristalls in Durchtrittsrichtung 13 zurückgelegte Weglänge W ist gemäß W=D/cos(NW) von der Plattendicke D und dem Neigungswinkel NW abhängig.

Aufgrund der doppelbrechenden Eigenschaften des Plattenmaterials breitet sich innerhalb der Platte 4 eine Lichtwelle mit zwei orthogonalen Schwingungsrichtungen aus, d.h. in Form von senkrecht zueinander polarisierten Feldkomponenten, wobei die Schwingungsrichtung 15 der einen Komponente in der Durchtrittsebene und die Schwingungsrichtung 16 der anderen Komponente senkrecht zur Durchtrittsebene verläuft. Für die Zwecke dieser Anmeldung wird die in der Durchtrittsebene schwingende Komponente 15 als ordentlicher Strahl (Index o) und die senkrecht dazu schwingende Komponente 16 als außerordentlicher Strahl (Index ao) bezeichnet. Für diese beiden Komponenten gelten bei doppelbrechenden Materialien im allgemeinen in Abhängigkeit von der Durchtrittsrichtung unterschiedliche Brechzahlen nₒ für den ordentlichen und nₐₒ für den außerordentlichen Strahl. Deren Verhältnis ist in Fig. 2 schematisch für den Fall eines negativ doppelbrechenden Kristalls gezeigt. Wie allgemein bekannt, ist die Brechzahl nₒ in allen Richtungen gleich, während sich die Brechzahl nₐₒ in Abhängigkeit vom Winkel NW zur Kristallachse 5 ändert. In Richtung der optischen Achse 5 verschwindet diese Aufspaltung (nₐₒ=nₒ), während senkrecht dazu die Betragsdifferenz Δn=|nₐₒ-nₒ| maximal wird (Δnₘₐₓ). Wie aus der Theorie der Verzögerungsplatten bekannt, verlassen die beiden senkrecht zueinander polarisierten Feldkomponenten das doppelbrechende Material ohne Richtungsdifferenz, aber mit einem Gangunterschied G, gemäß G=W x |nₐₒ-nₒ|.

Eine Besonderheit des Polarisators besteht nun darin, daß durch die Dimensionierung bzw. Auslegung der ablenkenden Strukturen der Neigunswinkel NW in gewissen Grenzen einstellbar ist, wobei der Neigungswinkel bei der gezeigten Lineargitterstruktur zunimmt, je geringer die Gitterkonstante (Abstand benachbarter Gitterlinien senkrecht zum Linienverlauf) ist. Anhand von Fig. 2 ist erkennbar, daß im Bereich kleiner Neigungswinkel, wenn also die Durchtrittsrichtung 13 in sehr spitzem Winkel zur Kristallachse 5 steht, die Brechzahldifferenz Δn sehr kleine Werte annehmen kann, die nur einen Bruchteil der maximalen Brechzahldifferenz Δnₘₐₓ betragen, welche bei einem rechten Winkel zwischen Lichtausbreitungsrichtung 13 und Kristallachse 5 auftreten würde. Die durch die Erfindung geschaffene Möglichkeit der Einstellung sehr kleiner Brechzahldifferenzen (bei gegebenem Plattenmaterial) führt dazu, daß die für einen gewünschten Gangunterschied G der Polarisationskomponenten am Ausgang des Polarisators erforderliche Plattendicke D bei erfindungsgemäßen Polarisatoren um ein Vielfaches höher sein kann als bei herkömmlichen Verzögerungsplatten, bei denen die Einfallsrichtung des Lichtes senkrecht auf der Kristallachse steht. Durch die Erfindung können also unbequem geringe Dicken von Polarisatoren vermieden werden, was sich besonders beim bevorzugten Einsatz großer Querschnitte vorteilhaft auswirkt.

Bei der in Fig. 1 gezeigten Ausführungsform sind die Plattendicke D und der Neigungswinkel NW (durch geeignete Gitterkonstanten der ablenkenden Gitter) so gewählt, daß sich entlang des Weges W zwischen den Feldkomponenten 15, 16 des durchtretenden Lichtes ein Gangunterschied G von einem Viertel der Wellenlänge des eintretenden Lichtes 2 ergibt. Dadurch wird, in Analogie zu einer Viertelwellenplatte, eintretendes zirkular polarisiertes Licht in austretendes linear polarisiertes Licht umgewandelt. Bei einer anderen Ausführungsform sind der Neigungswinkel NW und die Plattendicke D so aufeinander abgestimmt, daß sich zwischen den Polarisationskomponenten ein Halbwellen-Gangunterschied analog einer Halbwellenplatte einstellt. Derartige Polarisatoren sind dazu geeignet, eine Drehung der Polarisationsebene von einfallendem linear polarisiertem Licht zu bewirken.

Die Orientierung der Polarisationsvorzugsrichtung jedes Bereiches nach Austritt aus der Polarisatorplatte ist für jeden Bereich durch die Orientierung der ablenkenden Strukturen beeinflußbar. Deren Orientierung legt für jeden Bereich, also lokal, die Orientierung der Durchtrittsebene fest, und damit auch die Orientierung der Schwingungsrichtungen 15, 16 der senkrecht zueinander polarisierten Feldkomponenten. Diese Richtungen 15, 16 werden auch als induzierte Kristallachsen bezeichnet.

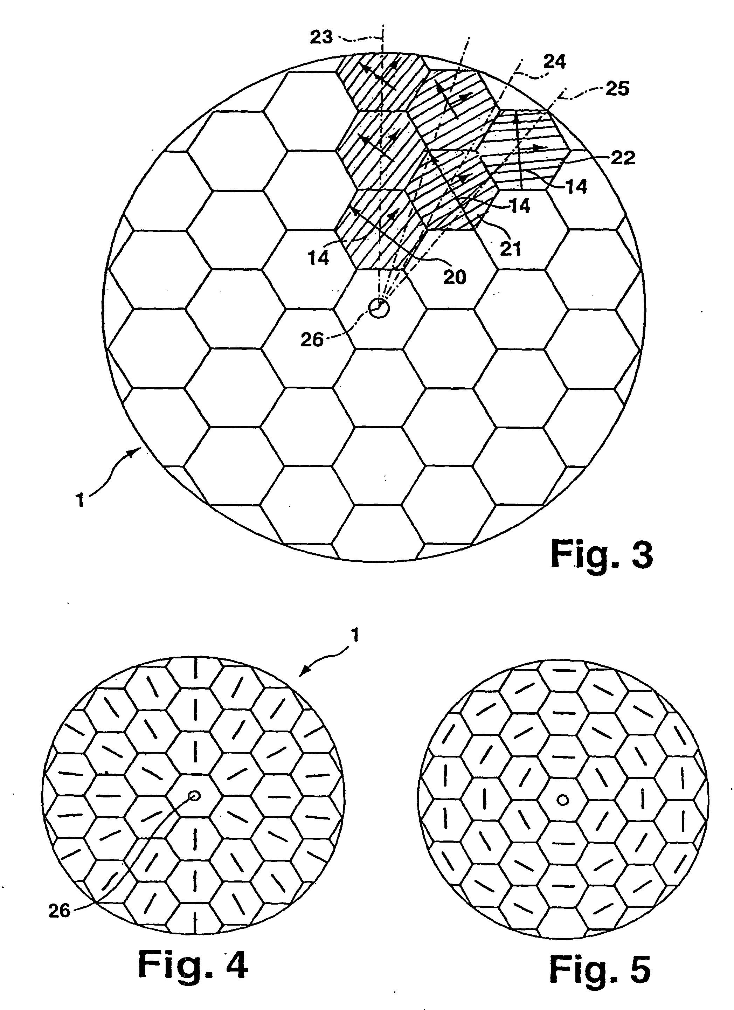

Die windschiefe Ablenkung erfindungsgemäßer Polarisatoren kann dazu genutzt werden, in einem Schritt aus einfallendem Licht 2 austretendes Licht 3 zu erzeugen, das für jeden Bereich, d.h. lokal, tangential oder radial polarisiert ist. Die windschiefe Ablenkung muß im Fall des zirkularen Eingangs unter 45° geschehen, so daß die induzierten Kristallachsen 15, 16 lokal auch unter einem Winkel von 45° zur gewünschten ausgangsseitigen radialen (oder tangentialen) Orientierung stehen. Dies wird anhand Fig. 3 näher erläutert, welche eine Draufsicht auf den Polarisator von Fig. 1 zeigt. Für einige ausgewählte, sechseckförmige Facetten bzw. Bereiche 20, 21, 22 sind jeweils die Orientierung der Gitterlinien der ablenkenden Struktur, die dadurch festgelegte Orientierung der Durchtrittsebene (veranschaulicht durch die Schnittlinie 14 zwischen Durchtrittsebene und Plattenoberseite 6) und die dementsprechende Orientierung der induzierten Kristallachsen (Pfeile) gezeigt. Weiterhin ist für jede der Facetten der der Facette zugeordnete Radius 23, 24, 25 von der optischen Achse 26 des Polarisators durch die Flächenmitte des jeweiligen Bereiches gezeigt.

Da für eine ausgangsseitige Radialpolarisation die induzierten Kristallachsen 15, 16 jeweils lokal unter 45° zur bereichsspezifischen Radialrichtung stehen müssen, stehen auch die Durchtrittsebenen in den Bereichen sowie die Linien der beugenden Strukturen jeweils im Winkel von 45° zur Radialrichtung. Damit bewirkt jede Viertelwellenplatten-Facette eine Umwandlung des eintretenden zirkular polarisierten Lichtes in austretendes linear polarisiertes Licht, dessen Polarisationsrichtung im Bereich der Facettenmitte genau in Radialrichtung verläuft (Fig. 4). Es ist zu erkennen, daß die für die Ablenkung verantwortlichen, beugenden Strukturen von der Mitte 26 des Polarisators nach Art von Turbinenschaufeln geschwungen nach außen laufen, allerdings nicht ununterbrochen, weil jeweils Felder bzw. Bereiche endlicher Größe mit konstanter Ablenkung gebildet sind. Über die Größe der Bereiche kann die für den jeweiligen Anwendungsfall maximal zulässige Richtungstoleranz, d.h. die Abweichung der lokalen Polarisation von der gewünschten durchgängig radialen Polarisation eingestellt werden. Auch ein kontinuierlicher Übergang zwischen lokalen Orientierungen ohne festgelegte Bereichsgrenzen ist möglich.

Das anhand eines Ausführungsbeispiels erläuterte Prinzip der Erfindung ist bei Polarisatoren für andere Fälle ohne weiteres ebenfalls anwendbar. So ist beispielsweise ein Polarisator zur Umwandlung von einfallendem zirkular polarisierten Licht in austretendes tangential polarisiertes Licht ausgehend von der in Fig. 3 gezeigten Struktur dadurch zu erreichen, daß die Gitterlinien der ablenkenden Strukturen in jedem Bereich um 90° in Bezug auf die Kristallachsenrichtung gedreht werden. Dann liegt jeweils am Ausgang eines Bereiches Licht mit tangentialer Polarisation vor, wie es in Fig. 5 gezeigt ist.

Das Prinzip ist auch nutzbar, um aus einfallendem Licht, das über seinen gesamten Querschnitt in einer Richtung linear polarisiert ist, durch lokale Drehung der Polarisationsebene ausfallendes linear polarisiertes Licht zu erzeugen, welches für jeden Bereich eine gewünschte Polarisationsrichtung hat, beispielsweise die in Fig. 4 gezeigte Radialpolarisation oder die in Fig. 5 gezeigte tangentiale 'Polarisation. Hierzu ist zunächst die Plattendicke D in Abstimmung mit dem Neigungswinkel NW so zu wählen, daß sich über die durchlaufende Weglänge W bei der vom Neigungswinkel abhängigen Brechzahldifferenz der gewünschte Gangunterschied einer halben Wellenlänge einstellt. Darüber hinaus sind die ablenkenden Strukturen in jedem Bereich so auszurichten, daß eine induzierte Kristallachse lokal genau auf der Winkelhalbierenden zwischen der Polarisationsrichtung des einfallenden Lichtes und der gewünschten Polarisationsrichtung (beispielsweise tangential oder radial) liegt. Bei Halbwellenplatten ergibt sich bekanntlich die Polarisationsrichtung des austretenden Lichtes durch Spiegelung der Richtung des eintretenden Lichtes an einer der induzierten Kristallachsen. Für die erwähnten Gangunterschiede können sich abhängig von der Plattendicke und der Winkelvariation des eintretenden Lichts Verzögerungsdifferenzen ergeben, die bei bevorzugten Ausführungsformen im Bereich von ± (5-10)% um den gewünschten Viertel- oder Halbwellengang-unterschied liegen können.

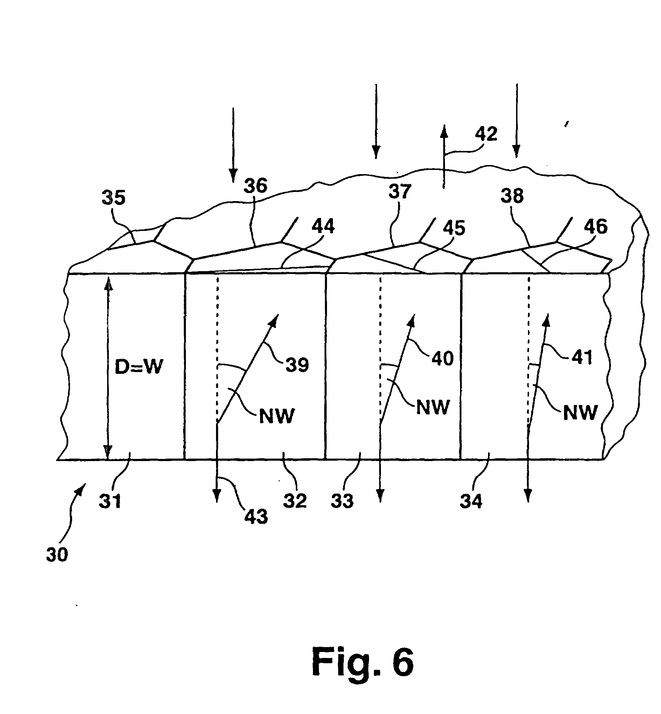

In Fig. 6 ist ein Beispiel einer anderen Ausführungsform eines erfindungsgemäßen Polarisators gezeigt. Der Polarisator 30 hat ebenfalls die Form einer planparallelen Platte mit axialer Dicke D, besteht jedoch im Unterschied zur Ausführungsform gemäß Fig. 1 aus mehreren untereinander z.B. durch Ansprengen verbundenen, doppelbrechenden optischen Elementen 31 bis 34 mit jeweils regelmäßig sechseckförmigem Querschnitt, die derart lückenlos aneinandergesetzt sind, daß sie einen insgesamt plattenförmigen Polarisator bilden. Die Größe der dadurch gebildeten Sechseckbereiche 35 bis 38 kann derjenigen, der in Fig. 1 gezeigten Sechseckbereiche entsprechen. Die optischen Elemente 31 bis 34 sind jeweils so aus einem Block aus doppelbrechendem Material herausgeschnitten, daß die Kristallachse 39, 40, 41 jeweils windschief zu den Seitenflächen bzw. Stirnflächen der Sechseckelemente steht. Dabei ist bei jedem Element der Neigungswinkel NW zwischen der Richtung der Kristallachse und der optischen Achse 42 des Polarisators gleich. Jedoch unterscheiden sich benachbarte optische Elemente im gezeigten Bereich dadurch, daß die kristallographischen Achsen der optischen Elemente jeweils unterschiedliche Drehpositionen um die optische Achse 42 einnehmen. Das bedeutet, daß die im allgemeinen kristallographischen Achsen der optischen Elemente, mit Ausnahme einiger Bereiche, nicht parallel zueinander verlaufen, sondern um die optische Achse 42 gegeneinander verdreht sind. Dies bewirkt, daß bei parallel zur optischen Achse 42 in Durchtrittsrichtung 43 durchtretendem Licht in jedem optischen Element eine andere Orientierung der Durchtrittsebene (aufgespannt durch Durchtrittsrichtung 43 und Kristallachse) auftritt. Dies wird durch die entsprechenden Schnittlinien 44 bis 46 der in den optischen Elementen 32, 33, 34 vorliegenden Durchtrittsebenen schematisch verdeutlicht.

Der Polarisator arbeitet analog zur oben beschriebenen Ausführungsform nach dem Prinzip einer Verzögerungsplatte. Das einfallende Licht wird bei Eintritt in den Polarisator in einen ordentlichen und einen außerordentlichen Strahl zerlegt, die sich entsprechend der jeweils für sie geltenden Brechzahl mit unterschiedlichen Geschwindigkeiten ausbreiten, was zu einem Gangunterschied G=W x |nₐₒ-nₒ| führt. Die durchlaufende Wegstrecke W entspricht der Plattendicke D, während sich die Brechzahldifferenz gemäß Fig. 2 aus dem Neigungswinkel NW ergibt, der beim Schneiden der optischen Elemente aus einem größeren Kristallblock festgelegt wird. Wie bei Ausführungsform gemäß Fig. 1 kann die Plattendicke D durch Wahl kleiner Neigungswinkel NW (und entsprechend geringer Brechzahldifferenzen) so groß werden, daß eine Platte mit gut handhabbarer Dicke geschaffen wird. Soll zirkular polarisiertes Licht in bereichsweise linear polarisiertes Licht umgewandelt werden, so wird die Dicke D so eingestellt, daß der Gangunterschied einer Viertelwellenlänge des Lichtes entspricht, zur Drehung der Polarisationsebene von linear polarisiertem Licht wird der Gangunterschied auf eine halbe Wellenlänge eingestellt. Die Orientierung des austretenden, linear polarisierten Lichtes wird für jeden Bereich durch die Orientierung der Durchtrittsebenen festgelegt. Diese können in Analogie zur Darstellung in Fig. 3 liegen, um einen Radialpolarisator zu erzeugen oder um 90° verdreht, um einen Tangentialpolarisator zu erzeugen. Ein Vorteil dieser Ausführungsform besteht vor allem darin, daß auf eine gegebenenfalls komplizierte Herstellung ablenkender Strukturen verzichtet werden kann.

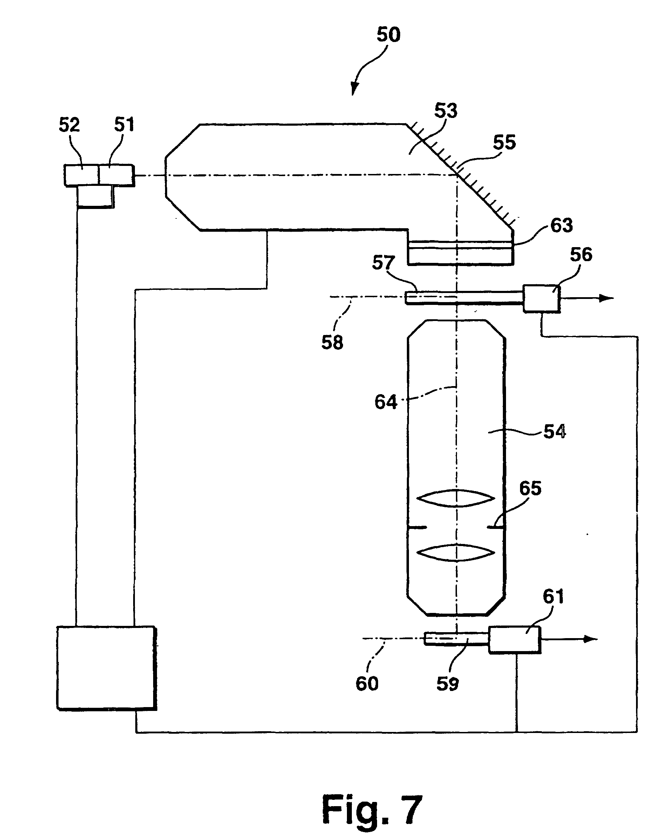

In Fig. 7 ist eine mikrolithographische Projektionsbelichtungsanlage 50 gezeigt, die mit einem erfindungsgemäßen Polarisator ausgestattet ist. Die Anlage, bei der es sich um einen Waferscanner handelt, umfaßt eine Laserlichtquelle 51 mit einer Einrichtung 52 zur Einengung der Bandbreite des Lasers, welcher linear polarisiertes Licht aussendet. Ein Beleuchtungssystem 53 erzeugt ein großes, scharf begrenztes und sehr homogen beleuchetetes Bildfeld, das an die Telezentrizitätserfordernisse des nachgeschalteten Projektionsobjektives 54 angepaßt ist. Das Beleuchtungssystem 53 hat Einrichtungen zur Auswahl des Beleuchtungsmodus und ist beispielsweise zwischen konventioneller Beleuchtung mit variablem Kohärenzgrad, Ringfeldbeleuchtung und Dipol- oder Quadropolbeleuchtung umschaltbar. Zur Verringerung der Baulänge des Systems umfaßt das Beleuchtungssystem einen Umlenkspiegel 55. Hinter dem Beleuchtungssystem ist eine Einrichtung 56 zum Halten und Manipulieren einer Maske 57 so angeordnet, daß diese in einer Bildebene 58 des Projektionsobjektives 54 liegt und mittels eines Scannantriebes in dieser Ebene bewegbar ist. Das Projektionsobjektiv 54 ist als rotationssymmetrisches, rein refraktives Reduktionsobjektiv ausgelegt, das ein Bild der Maske in reduziertem Maßstab auf einen mit einer Photoresistschicht belegten Wafer 59 abbildet, der in der Bildebene 60 des Objektivs 54 angeordnet ist und durch eine Einrichtung 61 gehalten wird, die einen Scannerantrieb umfaßt, um den Wafer synchron mit der Maske 57 zu bewegen. Alle Systeme werden von einer Steuereinheit 62 gesteuert.

Im Beleuchtungssystem 53 ist hinter dem Umlenkspiegel 55 ein erfindungsgemäßer Polarisator 63 in den Strahlengang eingesetzt. Er kann als einstückige Platte gemäß Ausführungsform Fig. 1 oder als segmentierter Polarisator gemäß Fig. 6 ausgelegt sein. Seine axiale Dicke ist so bemessen, daß er nach Art einer Halbwellenplatte wirkt und aus dem eintretenden, über den gesamten Querschnitt in einer Orientierung linear polarisierten Licht austretendes Licht mit radialer Polarisation (entsprechend Fig. 3) erzeugt. Diese radiale Polarisation liegt in der Maskenebene 58 vor und wird bis in die Bildebene 60 "durchgeschleust", da sich hinter dem Polarisator keine die Polarisation des Lichtes beeinflussenden Elemente, wie Spiegel o. dgl. befinden. Insbesondere bei hohen numerischen Aperturen wirkt sich die Radialpolarisation günstig auf die Transmission der beschichteten Linsen des Projektionsobjektives 54 aus, was die Bildintensität am Lichtaustritt und damit den Waferdurchsatz erhöht. Der Polarisator 63 ist entlang der optischen Achse 64 des Systems so angeordnet, daß er in einer Ebene liegt, die konjugiert zur Ebene der Systemblende 65 des Projektionsobjektives liegt. Dadurch kann eine lineare Polarisation als Funktion des Pupillenortes im Bereich der Systemblende erzeugt werden, ohne daß in diesem Bereich ein zusätzliches optisches Element eingebracht werden muß, was aufgrund begrenzten Bauraumes bei vielen Hochleistungsobjektiven nur schwierig oder überhaupt nicht möglich ist.

## Patentansprüche

1. Segmentiertes Verzögerungselement zur Umwandlung eines im wesentlichen senkrecht zu einer Eintrittsseite des Verzögerungselementes eintretenden Lichtbündels in ein austretendes Lichtbündel, welches über seinen Querschnitt eine vorgegebene Verteilung lokal unterschiedlicher Polarisationszustände aufweist, mit folgenden Merkmalen:
Zur Erzeugung einer Phasenverzögerung zwischen senkrecht zueinander polarisierten Feldkomponenten des durchtretenden Lichts ist mindestens ein doppelbrechendes Element (4, 31 bis 34) vorgesehen, das eine kristallographische Hauptachse (5, 39, 40, 41) und eine axiale Dicke (D) hat;
Der beleuchtete Querschnitt des Verzögerungselementes ist in eine Vielzahl von Bereichen (10, 11, 12, 20, 21, 22, 35 bis 38) aufgeteilt;
**gekennzeichnet durch**:
Mindestens einer der Bereiche ist so ausgebildet, daß die Durchtrittsrichtung (13, 43) des Lichtes, die sich bei einem Lichteinfall senkrecht zu einer Eintrittsseite (6) des Verzögerungselementes ergibt, in dem Bereich derart schief zur Richtung der kristallographischen Hauptachse (5, 39, 40, 41) des Bereichs verläuft, dass die Durchtrittsrichtung mit der kristallographischen Hauptachse einen Neigungswinkel (NW) von mehr als 0° und weniger als 90° einschließt und in einer **durch** die Durchtrittsrichtung und die Richtung der kristallographischen Hauptachse aufgespannten Durchtrittsebene liegt;
wobei für den Bereich die axiale Dicke (D) und der Neigungswinkel (NW) derart aneinander angepaßt sind, daß eine optische Weglängendifferenz der Feldkomponenten in dem Bereich nach Durchtritt **durch** das Verzögerungselement einem vorgegebenen Gangunterschied entspricht und die Orientierung der Durchtrittsebene (13, 43) für jeden Bereich (35 bis 38) so eingestellt ist, daß sich die für diesen Bereich lokal gewünschte Polarisationsvorzugsrichtung ergibt.

2. Verzögerungselement nach Anspruch 1, **dadurch gekennzeichnet, dass** jeder der Bereiche (10, 11, 12, 20, 21, 22, 35 bis 38) in der beschriebenen Weise ausgebildet ist.

3. Verzögerungselement nach Anspruch 1 oder 2, **dadurch gekennzeichnet, daß** ein doppelbrechendes Element (4) mit einer im wesentlichen senkrecht zu einer Eintrittsseite (6) ausgerichteten kristallographischen Hauptachse (5) vorgesehen ist und daß dem doppelbrechenden Element für mindestens einen, vorzugsweise jeden Bereich eine ablenkende Struktur (8) zugeordnet ist, die zur Erzeugung des für den Bereich vorgesehenen Neigungswinkel und der Neigungsrichtung ausgebildet ist, wobei vorzugsweise ein einziges den Querschnitt des Verzögerungselementes füllendes doppelbrechendes Element (4) vorgesehen ist.

4. Verzögerungselement nach einem der vorhergehenden Ansprüche, **dadurch gekennzeichnet, daß** auf der Eintrittsseite (6) des doppelbrechenden Elementes (4) ablenkende Strukturen (8) zur Ablenkung des einfallenden Lichtes (2) in die schiefe Durchtrittsrichtung (13) und auf der Austrittsseite (7) zugeordnete ablenkende Strukturen (9) zur Rückgängigmachung der Ablenkung vorgesehen sind.

5. Verzögerungselement nach Anspruch 3 oder 4, **dadurch gekennzeichnet, daß** das doppelbrechende Element eine Platte (4) aus doppelbrechendem Material ist, insbesondere aus Magnesiumfluorid oder Quarzkristall, wobei vorzugsweise die ablenkenden Strukturen (8, 9) direkt auf der Eintrittsseite (6) und/oder der Austrittsseite (7) der Platte ausgebildet sind.

6. Verzögerungselement nach einem der Ansprüche 3 bis 5, **dadurch gekennzeichnet, daß** mindestens eine ablenkende Struktur (8, 9) eine beugende Struktur ist, insbesondere ein lineares Gitter, und/oder daß mindestens eine ablenkende Struktur eine brechende Struktur ist, insbesondere nach Art einer Fresnel-Oberfläche, und/oder daß mindestens eine ablenkende Struktur eine beugende und brechende Struktur ist und/oder dass mindestens eine ablenkende Struktur eine holographische Struktur ist.

7. Verzögerungselement nach Anspruch 1 oder 2, **dadurch gekennzeichnet, daß** im Querschnitt des Verzögerungselementes (30) mehrere doppelbrechende Elemente (31 bis 34) vorzugsweise flächenfüllend angeordnet sind, jedes der Elemente einen Bereich bildet und eine axiale Dicke (D) hat und bei jedem der doppelbrechenden Elemente die kristallographische Hauptachse (39, 40, 41) derart schief gegenüber der Durchtrittsrichtung (43) des Lichts gekippt ist, daß die kristallographische Hauptachse mit der Durchtrittsrichtung die Durchtrittsebene aufspannt.

8. Verzögerungselement nach einem der vorhergehenden Ansprüche, **dadurch gekennzeichnet, daß** das Verzögerungselement (1, 30) zur Umwandlung von eintretendem zirkular polarisierten Licht in austretendes, bereichsweise linear polarisiertes Licht ausgebildet ist, wobei das austretende Licht vorzugsweise tangential oder radial polarisiert ist, wobei vorzugsweise der vorbestimmte Gangunterschied (G) im wesentlichen einem Viertel der Wellenlänge des eintretenden Lichts entspricht.

9. Verzögerungselement nach einem der Ansprüche 1 bis 7, **dadurch gekennzeichnet, daß** das Verzögerungselement (1, 30) zur Umwandlung von eintretendem, über seinen gesamten Querschnitt in einer Richtung linear polarisiertem Licht in austretendes, bereichsweise linear polarisiertes Licht ausgebildet ist, wobei das austretende Licht vorzugsweise tangential oder radial polarisiert ist, wobei vorzugsweise der vorbestimmte Gangunterschied (G) im wesentlichen einer halben Wellenlänge des eintretenden Lichts entspricht.

10. Verzögerungselement nach einem der vorhergehenden Ansprüche, **dadurch gekennzeichnet, daß** das Verzögerungselement (1, 30) insbesondere die Platte (4), eine axiale Dicke (D) von mehr als 100µm aufweist, wobei die axiale Dicke vorzugsweise zwischen ca. 200µm und ca. 600*µ*m liegt.

11. Verzögerungselement nach einem der vorhergehenden Ansprüche, **dadurch gekennzeichnet, daß** sein Querschnitt in kleine Bereiche (10, 11, 12, 20, 21, 22, 35 bis 38) konstanter Ablenkung und/oder gleichen Neigungswinkels (NW) aufgeteilt ist, die den gesamten beleuchteten Querschnitt des Verzögerungselementes vorzugsweise lückenlos ausfüllen, wobei die Bereiche vorzugsweise eine vieleckige, insbesondere sechseckige Form haben, und/oder daß sein Querschnitt in kleine Bereiche (10, 11, 12, 20, 21, 22, 35 bis 38), vorzugsweise mit gleicher Größe und/oder Form aufgeteilt ist, wobei die Anzahl der Bereiche in der Größenordnung von 10 oder darüber liegt.

12. Mikrolithographie-Projektionsanlage mit einer eine Lichtquelle (51) umfassenden Beleuchtungseinrichtung (53) zur Beleuchtung einer Maske (57) sowie mit einem der Beleuchtungseinrichtung (53) nachgeschalteten Projektionsobjektiv (54) zur Abbildung eines von der Maske (57) getragenen Musters in eine Bildebene (60) des Projektionsobjektives, **dadurch gekennzeichnet, daß** in die Projektionsanlage (50) mindestens ein Verzögerungselement (1, 30, 63) gemäß einem der Ansprüche 1 bis 11 eingebaut ist.

13. Mikrolithographie-Projektionsanlage nach Anspruch 12, **dadurch gekennzeichnet, daß** das Verzögerungselement (63) zwischen der Lichtquelle (51) und der Maske (57) in der Beleuchtungseinrichtung (53) eingebaut ist, vorzugsweise im Bereich einer Ebene, die zu einer Systemblende (65) des Projektionsobjektivs (54) konjugiert ist, und/oder daß das Verzögerungselement (63) in Lichtflußrichtung hinter dem letzten polarisierenden optischen Element, insbesondere hinter einem letzten Umlenkspiegel (55), angeordnet ist, und/oder daß das Verzögerungselement auswechselbar ist.

## Claims

1. Segmented retardation element for converting a light bundle entering the retardation element substantially perpendicular to an entrance side into an emerging light bundle which has over its cross section a prescribed distribution of locally different polarization states, having the following features:
in order to produce a phase retardation between field components, polarized perpendicular to one another, of the penetrating light, at least one birefringent element (4, 31 to 34) is provided which has a main crystallographic axis (5, 39, 40, 41) and an axial thickness (D);
the illuminated cross section of the retardation element is divided into a multiplicity of zones (10, 11, 12, 20, 21, 22, 35 to 38); **characterized in that**;
at least one of the zones is designed such that the transit direction (13, 43) of the light which results in the case of an incidence of light perpendicular to an entrance side (6) of the retardation element runs in the zone obliquely in the direction of the main crystallographic axis (5, 39, 40, 41) of the zone in such a way that the transit direction encloses with the main crystallographic axis an angle of inclination (NW) of more than 0° and less than 90° and lies in a transit plane defined by the transit direction and the direction of the main crystallographic axis;
the axial thickness (D) and the angle of inclination (NW) being adapted to one another for the zone in such a way that an optical path length difference of the field components in the zone after passage through the retardation element corresponds to a prescribed path difference, and the orientation of the transit plane (13, 43) is set for each zone (35 to 38) so as to produce the preferred polarization direction desired locally for this zone.

2. Retardation element according to Claim 1, **characterized in that** each of the zones (10, 11, 12, 20, 21, 22, 35 to 38) is designed in the way described.

3. Retardation element according to Claim 1 or 2, **characterized in that** a birefringent element (4) having a main crystallographic axis (5) aligned substantially perpendicular to an entrance side (6) is provided, and **in that** for at least one, preferably each zone the birefringent element is assigned a deflecting structure (8) which is designed to produce the angle of inclination provided for the zone and to produce the direction of inclination, a single birefringent element (4) filling the cross section of the retardation element preferably being provided.

4. Retardation element according to one of the preceding claims, **characterized in that** deflecting structures (8) for deflecting the incident light (2) into the oblique transit direction (13) are provided on the entrance side (6) of the birefringent element (4), and assigned deflecting structures (9) for cancelling the deflection are provided on the exit side (7).

5. Retardation element according to Claim 3 or 4, **characterized in that** the birefringent element is a plate (4) made from birefringent material, in particular from magnesium fluoride or quartz crystal, the deflecting structures (8, 9) preferably being formed directly on the entrance side (6) and/or the exit side (7) of the plate.

6. Retardation element according to one of Claims 3 to 5, **characterized in that** at least one deflecting structure (8, 9) is a diffracting structure, in particular a linear grating, and/or **in that** at least one deflecting structure is a refracting structure, in particular of the type of a Fresnel surface, and/or **in that** at least one deflecting structure is a diffracting and refracting structure, and/or **in that** at least one deflecting structure is a holographic structure.

7. Retardation element according to Claim 1 or 2, **characterized in that** a plurality of birefringent elements (31 to 34) are preferably arranged to fill the area of the cross section of the retardation element (30), each of the elements forms a zone and has an axial thickness (D), and for each of the birefringent elements the main crystallographic axis (39, 40, 41) is tilted obliquely to the transit direction (43) of the light in such a way that the main crystallographic axis and the transit direction define the transit plane.

8. Retardation element according to one of the preceding claims, **characterized in that** the retardation element (1, 30) is designed to convert incoming, circularly polarized light into outgoing, partially linearly polarized light, the outgoing light preferably being tangentially or radially polarized, the predetermined path difference (G) preferably corresponding substantially to a quarter of the wavelength of the incoming light.

9. Retardation element according to one of Claims 1 to 7, **characterized in that** the retardation element (1, 30) is designed to convert incoming light, linearly polarized in one direction over, its entire cross section, into outgoing, partially linearly polarized light, the outgoing light preferably being tangentially or radially polarized, the predetermined path difference (G) corresponding substantially to half a wavelength of the incoming light.

10. Retardation element according to one of the preceding claims, **characterized in that** the retardation element (1, 30), in particular the plate (4), has an axial thickness (D) of more than 100 µm, the axial thickness preferably being between approximately 200 µm and approximately 600 µm.

11. Retardation element according to one of the preceding claims, **characterized in that** its cross section is divided into small zones (10, 11, 12, 20, 21, 22, 35 to 38) of constant deflection and/or equal angle of inclination (NW) which preferably fill up the entire illuminated cross section of the retardation element without gaps, the zones preferably having a polygonal, in particular hexagonal shape, and/or **in that** its cross section is divided into small zones (10, 11, 12, 20, 21, 22, 35 to 38), preferably of the same size and/or shape, the number of zones being of the order of magnitude of 10 or there above.

12. Microlithography projection machine having an illuminating device (53), comprising a light source (51), for illuminating a mask (57), and having a projection objective (54), arranged downstream of the illuminating device (53), for projecting a pattern, supported by the mask (57), into an image plane (60) of the projection objective, **characterized in that** at least one retardation element (1, 30, 63) in accordance with one of Claims 1 to 11 is installed in the projection machine (50).

13. Microlithography projection machine according to Claim 12, **characterized in that** the retardation element (63) is installed between the light source (51) and the mask (57) in the illuminating device (53), preferably in the region of a plane which is congruent with a system diaphragm (65) of the projection objective (54), and/or **in that** the retardation element (63) is arranged in the direction of flow of light downstream of the last polarizing optical element, in particular downstream of a last deflecting mirror (55), and/or **in that** the retardation element is interchangeable.

## Revendications

1. Élément de retard segmenté destiné à convertir un faisceau lumineux qui pénètre pour l'essentiel perpendiculairement à un côté d'entrée de l'élément de retard en un faisceau lumineux sortant qui présente sur sa section transversale une distribution prédéfinie de différents états de polarisation locaux, possédant les caractéristiques suivantes :
Pour produire un retard de phase entre les composants de champ polarisés perpendiculairement l'un par rapport à l'autre de la lumière traversante, il est prévu au moins un élément biréfringent (4, 31 à 34) qui possède un axe cristallographique principal (5, 39, 40, 41) et une épaisseur axiale (D) ;
La section transversale illuminée de l'élément de retard est divisée en une pluralité de zones (10, 11, 12, 20, 21, 22, 35 à 38) ;
**caractérisé en ce que** :
au moins l'une des zones est configurée de telle sorte que le sens de traversée (13, 43) de la lumière qui est obtenu lors d'une incidence de la lumière perpendiculairement à un côté d'entrée (6) de l'élément de retard s'étend dans la zone en biais par rapport au sens de l'axe cristallographique principal (5, 39, 40, 41) de la zone de telle sorte que le sens de traversée englobe avec l'axe cristallographique principal un angle d'inclinaison (NW) de plus de 0° et inférieur à 90° et se trouve dans un plan de traversée qui s'étend sur le sens de traversée et le sens de l'axe cristallographique principal ;
l'épaisseur axiale (D) et l'angle d'inclinaison (NW) étant adaptés l'un à l'autre pour la zone de telle sorte qu'une différence de longueur d'onde optique des composants du champ dans la zone après la traversée à travers l'élément de retard correspond à une différence de chemin prédéfinie et l'orientation du plan de traversée (13, 43) pour chaque zone (35 à 38) est réglée de telle manière à obtenir pour cette zone un sens de polarisation préférentiel local souhaité.

2. Élément de retard selon la revendication 1, **caractérisé en ce que** chacune des zones (10, 11, 12, 20, 21, 22, 35 à 38) est configurée de la manière décrite.

3. Élément de retard selon la revendication 1 ou 2, **caractérisé en ce qu'**il est prévu un élément biréfringent (4) dont l'axe cristallographique principal (5) est orienté pour l'essentiel perpendiculairement à un côté d'entrée (6) et qu'à l'élément biréfringent est associée une structure de déviation (8) pour au moins une, de préférence pour chacune des zones, laquelle est configurée pour produire l'angle d'inclinaison et le sens d'inclinaison prévus pour la zone, un seul élément biréfringent (4) remplissant la section transversale de l'élément de retard étant de préférence prévu.

4. Élément de retard selon l'une des revendications précédentes, **caractérisé en ce que** des structures de déviation (8) destinées à dévier la lumière incidente (2) dans le sens de traversée oblique (13) sont prévues sur le côté d'entrée (6) de l'élément biréfringent (4) et des structures de déviation (9) associées destinées à annuler la déviation sont prévues du côté de sortie (7).

5. Élément de retard selon la revendication 3 ou 4, **caractérisé en ce que** l'élément biréfringent est une plaque (4) en matériau biréfringent, notamment en fluorure de magnésium ou en cristal de quartz, les structures de déviation (8, 9) étant de préférence configurées directement sur le côté d'entrée (6) et/ou sur le côté de sortie (7) de la plaque.

6. Élément de retard selon l'une des revendications 3 à 5, **caractérisé en ce qu'**au moins une structure de déviation (8, 9) est une structure diffractante, notamment une grille linéaire, et/ou qu'au moins une structure de déviation est une structure réfringente, notamment à la manière d'une surface de Fresnel, et/ou qu'au moins une structure de déviation est une structure diffractante et réfringente et/ou qu'au moins une structure de déviation est une structure holographique.

7. Élément de retard selon la revendication 1 ou 2, **caractérisé en ce que** plusieurs éléments biréfringents (31 à 34) sont disposés de préférence de manière à remplir la surface dans la section transversale de l'élément de retard (30), chacun des éléments forme une zone et possède une épaisseur axiale (D) et sur chacun des éléments biréfringents, l'axe cristallographique principal (39, 40, 41) est incliné en biais par rapport au sens de traversée (43) de la lumière de telle sorte que l'axe cristallographique principal, avec le sens de traversée, englobe le plan de traversée.

8. Élément de retard selon l'une des revendications précédentes, **caractérisé en ce que** l'élément de retard (1, 30) est configuré pour convertir la lumière entrante à polarisation circulaire en une lumière sortante à polarisation linéaire en zones, la lumière sortante étant de préférence polarisée de manière tangentielle ou radiale, la différence de chemin prédéfinie (G) correspondant de préférence pour l'essentiel à un quart de la longueur d'onde de la lumière entrante.

9. Élément de retard selon l'une des revendications 1 à 7, **caractérisé en ce que** l'élément de retard (1, 30) est configuré pour convertir la lumière entrante à polarisation linéaire dans une direction sur toute sa section transversale en une lumière sortante à polarisation linéaire en zones, la lumière sortante étant de préférence polarisée de manière tangentielle ou radiale, la différence de chemin prédéfinie (G) correspondant de préférence pour l'essentiel à un demi de la longueur d'onde de la lumière entrante.

10. Élément de retard selon l'une des revendications précédentes, **caractérisé en ce que** l'élément de retard (1, 30), notamment la plaque (4), présente une épaisseur axiale (D) supérieure à 100 µm, l'épaisseur axiale étant de préférence comprise entre environ 200 µm et environ 600 µm.

11. Élément de retard selon l'une des revendications précédentes, **caractérisé en ce que** sa section transversale est divisée en petites zones (10, 11, 12, 20, 21, 22, 35 à 38) de déviation constante et/ou d'angles d'inclinaison (NW) identiques qui remplissent de préférence sans vides l'ensemble de la section transversale illuminée de l'élément de retard, les zones ayant de préférence une forme polygonale, plus précisément hexagonale, et/ou que sa section transversale est divisée en petites zones (10, 11, 12, 20, 21, 22, 35 à 38) de préférence de tailles et/ou de formes identiques, le nombre de zones étant de l'ordre de 10 ou plus.

12. Équipement de projection microlithographique muni d'un dispositif d'éclairage (53) comprenant une source de lumière (51) pour illuminer un masque (57) ainsi qu'un objectif de projection (54) monté à la suite du dispositif d'illumination (53) pour représenter un modèle porté par le masque (57) dans un plan d'image (60) de l'objectif de projection, **caractérisé en ce qu'**au moins un élément de retard (1, 30, 63) selon l'une des revendications 1 à 11 est intégré dans l'équipement de projection (50).

13. Équipement de projection microlithographique selon la revendication 12, **caractérisé en ce que** l'élément de retard (63) est monté dans le dispositif d'illumination (53) entre la source de lumière (51) et le masque (57), de préférence dans la zone d'un plan qui est conjugué avec un obturateur modulaire (65) de l'objectif de projection (54), et/ou que l'élément de retard (63) est disposé dans le sens de circulation de la lumière derrière le dernier élément optique polarisant, notamment derrière un dernier miroir de déviation (55), et/ou que l'élément de retard est interchangeable.
